# EUROPEAN PATENT APPLICATION

(11) **EP 1 818 699 A1**
(43) Date of publication of application: **15.08.2007**
(21) Application number: 07107009.8
(22) Date of filing: 27.06.2003
(51) Int. Cl.: G02B 6/124, G02B 5/18, G11B 7/0065

(54) **Writing of photo-induced structures**

(30) Priority: 28.06.2002 AU PS328402
(62) Divisional of application: 03735149.1
(71) Applicant: Australian Photonics Pty Ltd, Eveleigh, New South Wales 1430 (AU); THE UNIVERSITY OF SYDNEY, Sydney, New South Wales 2006 (AU)
(72) Inventor: Sceats, Mark, New South Wales, 2006 (AU); Stepanov, Dimitrii, New South Wales, 2133 (AU)
(74) Representative: Rupp, Christian

(57) **Abstract**

A method of writing a photo-induced structure into a photosensitive material substrate, the method comprising the steps of creating an interference pattern utilising at least two light beams, exposing the substrate to the interference pattern for photo-inducing material changes in the substrate, and creating an irregularity in the interference pattern by controlling a wavefront of at least one of the beams, for creating a functional defect in the photo-induced structure.

## Description

### Field of the invention

The present invention relates broadly to a method of writing a photo-induced structure into a photosensitive material substrate, an interferometer for writing a photo-induced structure into a photosensitive material substrate, and to a photo-induced structure written into a photosensitive material substrate. The present invention will be described herein with reference to the direct writing of diffractive and refractive structures into photosensitive materials, however, it will be appreciated that the present invention does have broader applications, including e.g. writing of masks or fabrication of high resolution arrayed structures such as for use in screens/monitors, or in imaging interference lithography.

### Background of the invention

The writing of photo-induced structures into photosensitive material substrates is a technique suitable for a variety of applications. Such applications include the creation of optical structures in a photosensitive material, e.g. a waveguide, the fabrications of masks, e.g. optical diffraction masks or masks for lithography-type or etching-type processes, or the fabrication of high resolution arrayed structures, such as for use in screens/monitors.

The direct writing of diffractive structures into photosensitive materials, such as the writing of Bragg gratings into an optical fibre, has become a major field of research within photonics technology. While the writing of Bragg gratings into optical fibres has been successfully implemented in a number of commercial production processes worldwide, current and future efforts in that area are expected to concentrate on extending direct photo-induced structure writing processes to two dimensional structures, e.g. the writing of photonics circuits into wafer-type substrates.

One of the key challenges in extending direct photo-induced structure writing techniques into that area is to achieve high two-dimensional resolution in the writing of such extended area structures.

It has been proposed to reduce the size of an interference region of light beams used in the direct diffractive writing as far as possible, e.g. to 5 to 10 microns, and to achieve high two-dimensional resolution writing through a combination of translation and transverse lateral oscillation/scanning of the beams.

A major disadvantage of such an approach is that the achievable two-dimensional resolution will depend strongly not only on the beam size, but also on the ability to control the transverse lateral oscillation/scanning of the beams in a manner such that "seamless" transitions are created during successive oscillations/scans, which are required to create structures of defined optical properties.

In at least preferred embodiments, the present invention seeks to provide a novel direct photo-induced structure writing technique in which the achievable two-dimensional resolution is smaller than the size of an interference region of beams utilised during the writing process. Accordingly, in at least preferred embodiments, the present invention seeks to provide a technique in which the interference region can be kept at a larger size more suitable to achieve seamless writing of extended photonics circuits while at the same time achieving high two-dimensional resolution.

### Summary of the invention

In accordance with a first aspect of the present invention there is provided a method of writing a photo-induced structure into a photosensitive material substrate, the method comprising the steps of creating an interference pattern utilising at least two light beams, exposing the substrate to the interference pattern for photo-inducing material changes in the substrate, and creating an irregularity in the interference pattern by controlling a wavefront of at least one of the beams, for creating a functional defect in the photo-induced structure.

Accordingly, photo-induced structures can be written in which the resolution is smaller than the size of the interference region, which is of the order of the beam size of the light beams used. In other words, the present invention can provide a method of writing a photo-induced structure in which the resolution is smaller than the beam size, in contrast with prior art methods.

Preferably, the step of controlling the wavefront of at least one of the beams comprises utilising adaptive optics means for altering the wavefront. The adaptive optics means may be a reflective or transmissive adaptive optics means. The adaptive optics means may comprise a micro electronic mechanical system (MEMS) device. The MEMS device may comprise an array of movable micro mirrors.

The adaptive optics means may comprise a device based on liquid crystal (LC) technology. The device can further be based on ferroelectric liquid crystal (FLC) technology. The device can further be based on electrically controllable FLC retarder plates. As such, the device can operate as a transmissive phase modulator array. Placed between crossed polarisers, the device can operate as a transmissive intensity modulator array.

In one embodiment, the adaptive optics means may further be utilised to split an incoming light beam to create the at least two light beams for creation of the interference pattern.

The functional defect may comprise a linear defect, whereby the resulting 1-dimensional photo-induced structure exhibits a transmission resonance.

The method may comprise creating a 2-dimensional or 3-dimensional interference pattern. The functional defect in such an embodiment may comprise a 2-dimensional or 3-dimensional defect. The 2-dimensional or 3-dimesnsional defect may comprise an extended defect, whereby the resulting 2-dimensional or 3-dimensional photo-induced structure can be used to steer light into a desired direction.

The functional defect may comprise a dislocation defect, whereby the resulting photo-induced structure is asymmetric.

The method may further comprise the steps of inducing a relative movement between the substrate and an interference region of the beams, controlling a relative phase difference between the beams to induce changes in the interference pattern, and controlling a velocity of the changes in the interference pattern to write an extended photo-induced structure in the substrate. The relative movement may be effected through movement of the substrate and/or scanning of the beams. In one embodiment, the relative movement is effected through a combination of movement of the substrate and simultaneous scanning of the beams in a direction transverse to the movement of the substrate.

In such embodiments, the method may further comprise the step of further controlling the wavefront of at least one of the beams as a function of the relative movement, whereby the position and/or size and/or shape of the functional defect along the resulting photo-induced extended structure is controlled. The method may further comprise the step of controlling the wavefront of at least one of the beams to change the number of defects created along the photo-induced extended structure.

The method may further comprise the step of controlling the relative phase difference between the beams to vary a pitch of the interference pattern, or to vary a contrast of the interference pattern. The contrast of the interference pattern may be controlled to be zero for writing a photo-induced refractive structure. The adaptive optics means may be utilised in the controlling of the phase difference between the beams.

In one embodiment, the method further comprises the step of shaping the beams to control the exposure of the substrate to the interference pattern. The adaptive optics means may be utilised in the shaping of the beams.

The method may further comprise the step of focusing the light beams in the interference region.

In one embodiment, the method further comprises the step of applying feedback corrections during the writing of the photo-induced structure, to achieve desired characteristics of the written photo-induced structure. Preferably, the feedback corrections are conducted utilising a computer controlled process.

In one embodiment, the photosensitive material substrate has a non-linear photosensitivity, and one or more of the beams are pulsed laser beams, whereby a three-dimensional photo-induced structure can be written in the substrate utilising intensity variations in the created interference pattern.

The material change may e.g. comprise a refractive index change, a change in solubility, change in density, change in light transmission/absorption, and/or change in susceptibility to the next technological process, e.g. to a developer solution.

The method may further comprise the step of controlling the polarisation of at least one of the light beams. Accordingly, a symmetry of the resulting interference pattern can be controlled.

The method may further comprise applying the principles of imaging interference lithography to capture non-repetitive features and high spatial frequency information from the adaptive optics means.

In accordance with a second aspect of the present invention there is provided an interferometer for writing a photo-induced structure into a photosensitive material substrate, the interferometer comprising an interference unit for creating an interference pattern utilising at least two light beams, and a control unit for controlling a wavefront of at least one of the beams to create an irregularity in the interference pattern for creating a functional defect in the photo-induced structure.

Preferably, the control unit comprises an adaptive optics element for controlling the wavefront of at least one of the beams for altering the wavefront. The adaptive optics element may be a reflective or transmissive adaptive optics element. The adaptive optics element may comprise a micro electronic mechanical system (MEMS) device. The MEMS device may comprise an array of movable micro mirrors.

The adaptive optics element may comprise a transmissive device based on liquid crystal (LC) technology. The device can further be based on ferroelectric liquid crystal (FLC) technology. The device can further be based on electrically controllable FLC retarder plates. As such, the device can operate as a transmissive phase modulator array. Placed between crossed polarisers, the device can operate as a transmissive intensity modulator array.

In one embodiment, the adaptive optics element may further be arranged for splitting an incoming light beam to create the at least two light beams for creation of the interference pattern.

The functional defect may comprise a linear defect, whereby the resulting 1-dimensional photo-induced structure exhibits a transmission resonance.

The interference unit may be arranged for creating a 2-dimensional or 3-dimensional interference pattern. The functional defect in such an embodiment may comprise a 2-dimensional or 3-dimensional defect. The 2-dimensional or 3-dimensional defect may comprise an extended defect, whereby the resulting 2-dimensional or 3-dimensional photo-induced structure can be used to steer light into a desired direction.

The functional defect may comprise a dislocation defect, whereby the resulting photo-induced structure is asymmetric.

The control unit may further be arranged for controlling a relative phase difference between the beams to induce changes in the interference pattern, and controlling a velocity of the changes in the interference pattern to write an extended photo-induced structure in the substrate.

The interferometer may further comprise a scanning unit for scanning of the beams during the writing of the photo-induced structure.

The control unit may further be arranged for controlling the wavefront of at least one of the beams as a function of the relative movement in a manner such as to control the position and/or size and/or shape of the functional defect along the photo-induced extended structure. The control unit may further be arranged for controlling the wavefront of at least one of the beams to change the number of defects created along the photo-induced extended structure.

The control unit may further be arranged for controlling the relative phase difference between the beams to vary a pitch of the interference pattern, or to vary a contrast of the interference pattern. The contrast of the interference pattern may be controlled to be zero for writing a photo-induced refractive structure. The control unit may be arranged to utilise the adaptive optics element for the controlling of the relative phase difference.

The interferometer may further comprise a beam shaping unit for shaping the beams to, in use, control the exposure of the substrate to the interference pattern. The beam shaping unit may comprise the adaptive optics element.

The interferometer may further comprise a focusing unit for focusing the light beams in the interference region.

In one embodiment, the interferometer further comprises a feedback unit for applying feedback corrections during the writing of the photo-induced structure, to achieve desired characteristics of the written photo-induced structure. Preferably, the feedback unit comprises a computer processor.

In one embodiment, the photosensitive material substrate has a non-linear photosensitivity, and one or more of the beams are pulsed laser beams, whereby a three-dimensional photo-induced structure can be written in the substrate utilising intensity variations in the created interference pattern.

The material change may e.g. comprise a refractive index change, a change in solubility, change in density, change in light transmission/absorption, and/or change in susceptibility to the next technological process, e.g. to a developer solution.

The control unit may further be arranged for controlling a polarisation of at least one of the beams.

In accordance with a third aspect of the present invention there is provided a photo-induced structure written into a photosensitive material substrate utilising the method or the interferometer of the first or second aspect respectively.

### Brief description of the drawings

Preferred embodiment of the present invention will now be described, by way of example only, with reference to the accompanying drawings:
Figure 1 is a schematic drawing of an interferometer setup embodying the present invention.
Figure 2 is a schematic drawing of a detail of Figure 1.
Figures 3A and B are schematic drawings illustrating polarisation states of writing beams for a photo-induced structure in an example embodiment.
Figures 4A-D are schematic drawings illustrating polarisation states of writing beams for a photo-induced structure in an example embodiment.
Figures 5 and 6 are schematic drawings illustrating the effects of wavefront control in one of the writing beams in an example embodiment.
Figure 7 is a schematic drawing of a photo-induced structure embodying the present inventions.
Figure 8 is a schematic drawing of a photo-induced structure embodying the present inventions.
Figure 9 is a schematic drawing of a photo-induced structure embodying the present inventions.
Figure 10 is a schematic drawing of a photo-induced structure embodying the present inventions.
Figure 11 is a schematic drawing of a photo-induced structure embodying the present inventions.
Figure 12 is a schematic drawing of a photo-induced structure embodying the present inventions.
Figure 13 is a schematic drawing of a photonics circuit embodying the present invention.

### Detailed description of the embodiments

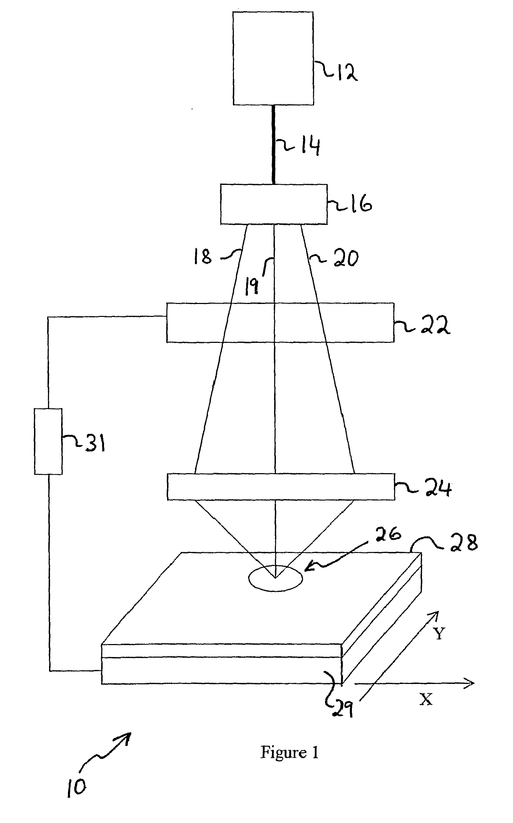

Figure 1 shows a schematic drawing of an interferometer setup 10 embodying the present invention. The interferometer 10 comprises a light source, in the example embodiment a UV laser source 12 for generating a UV laser beam 14. The laser beam 14 is subjected to a beam splitter unit 16 for splitting the beam 14 into three coherent writing beams 18 to 20. The three writing beams 18 to 20 are then subjected to a beam control unit 22 prior to being subjected to a beam combiner system 24 for focusing the writing beams 18 to 20 into an interference region 26 substantially in the plane of a photosensitive substrate 28. Photo-induced material changes, e.g. refractive index changes, are utilised for "writing" photo-induced structures in the substrate 28, e.g. diffractive structures.

The substrate 28 may comprise a photosensitive polymer. The substrate 28 may comprise a photosensitive material formed as a material layer on an underlying base substrate, for use as a resist for the subsequent etching of a photonics circuit into the base substrate material itself by processes such as reactive ion etching. The base substrate itself could, for example, comprise silica glass, semi-conductive materials such as silicon, II-V semi-conductors (InP, GaAs, GaN) or crystalline materials such as lithium niobate. Furthermore, multilayer circuits can be written if required by repeating the process steps, e.g. with thin metallic layers as a protection layer between subsequent functional layers.

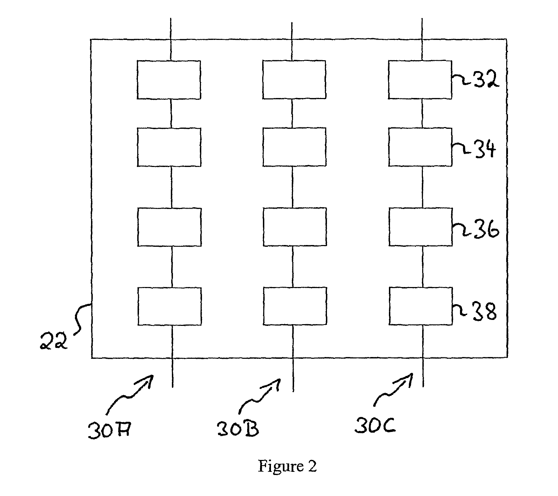

In Figure 2, details of the beam control unit 22 are shown for the example embodiment. The beam control unit 22 comprises, for each writing beam 18 to 20, a set of control elements 30A, 30B and 30C. Each set 30A, B, C comprises a phase/frequency modulator 32, a polarisation modulator 34, and an intensity modulator 36. Each set 30A, B, C further comprises an adaptive optics unit 38. Each adaptive optics unit 38 is arranged to control/modify the wavefront of one of the writing beams 18 to 20, in the example embodiment at a wavelength or a sub-wavelength size of the writing beams 18 to 20.

Returning now to Figure 1, the interferometer setup 10 allows for photo-induced structures to be written in the frame of the moving substrate 28, with the movement being maintained along an X axis which follows a photonics circuit to be written, with slow changes capable of being made by a Y axis controller (not shown). The movement of the substrate 28 is effected through a translation stage 29.

In use, precision measurement of the position and velocity of the translation stage 29 allows feedback control (CPU 31) to be made to the phases of the writing beams 18 to 20 in the interferometer setup 10 to write the diffractive structure in the frame of the moving substrate 28, by controlling a velocity of changes in the interference pattern within the interference region 26 relative to the translation of the substrate 28.

It is noted that the interferometer setup 10 also allows for the writing of waveguide structures, as opposed to diffractive structures, in the photosensitive substrate 28. Waveguide structures are defined by a refractive index profile that guides the light by refraction, and includes elements such as straight guides, bends, multi-mode interference structures (MMI's) and couplers. Through appropriate control of the writing beams 18 to 20, interference can be suppressed. In such a configuration, a substantially uniform photo-induced material index change occurs in the photosensitive substrate 28. It will be appreciated by a person skilled in the art that through relative movement between the substrate 28 and the interference region 26, in the example embodiment through appropriate control of the translation stage 29, refractive i.e. waveguide structures can be written.

In an alternative embodiment, a further light beam may be provided dedicated to the writing of waveguide/refractive structures, i.e. in such an embodiment, the writing is switched between utilising the dedicated single beam for waveguide/refractive structures writing, and utilising the interfering writing beams for writing of diffractive structures.

The pitch of photo-induced structures to be written can be changed by further phase or frequency modulation (phase/frequency modulators 32 in Figure 2) applied to the individual writing beams 18 to 20. Appropriate control can allow the superposition of many periods through Fourier synthesis, which can be used for the writing of complex photo-induced structures, e.g. diffractive dense wavelength division multiplexed (DWDM) filters.

The layout of the photo-induced structures to be written depends on the polarisation of the individual beams, and these can be individually controlled (polarisation modulators 34 in Figure 2).

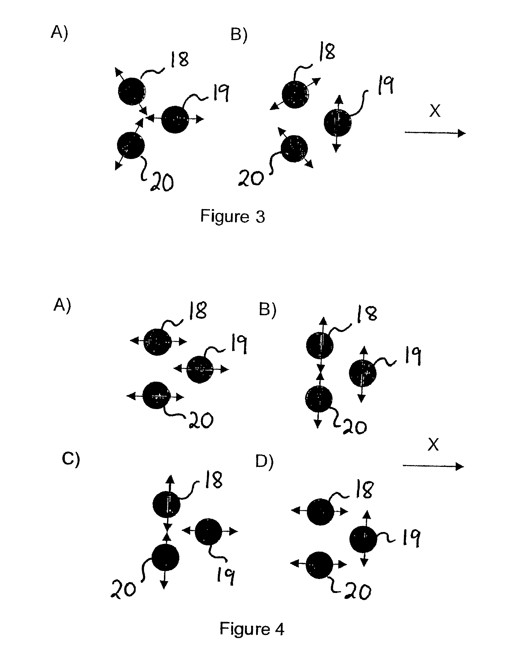

Figures 3A and B show example polarisation settings for the writing beams 18 to 20, which give rise to the maximum and equal contrast and for writing two-dimensional diffraction structures with an axis of symmetry about the X-axis.

Figures 4A and B show further polarisation settings that give rise to the writing of 2-dimensional photo-induced structures, whereas Figures 4C and D show example polarisation settings which give rise to the writing of 1-dimensional diffractive structures.

In the following, the use of the adaptive optics units 38 (Figure 2) for controlling the wavefronts of the writing beams 18 to 20 and the use of that technique to create irregularities in the resulting interference pattern, which in turn can be utilised to introduce functional defects in the written photo-induced structure, will be described.

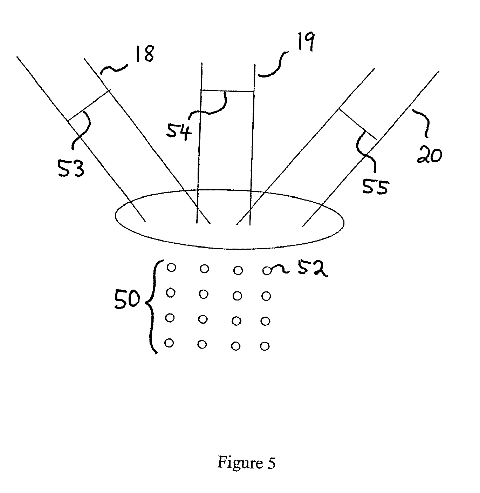

Turning initially to Figure 5, it is assumed that the writing beams 18 to 20 are controlled in a manner such that the resultant interference pattern comprises a two-dimensional array 50 of higher intensity spots e.g. 52. As shown in Figure 5, the wavefronts 53 to 55 of the writing beams 18 to 20 respectively are un-modified.

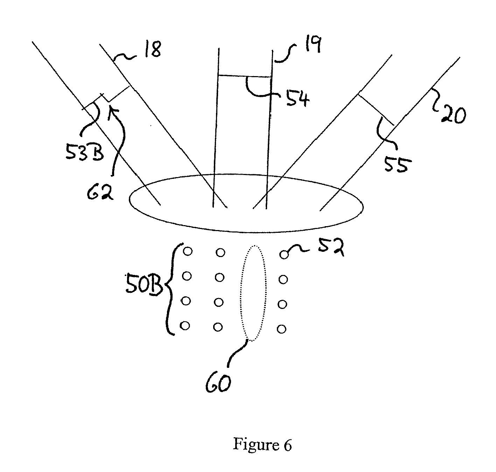

Turning now to Figure 6, there is shown an example configuration in which the wavefronts 53B of one of the writing beams, 18, has been modified to a step profile transversely across the beam 18 with a λ/2 phase "jump" at numeral 62. It will be appreciated by the person skilled in the art that as a result, the interference pattern will contain a modified array 50B of higher intensity spots e.g. 52, in which one "column" 60 is cancelled out.

It will be appreciated by the person skilled in the art that in embodiments of the present invention, a two-dimensional resolution in the control of the interference pattern 50, 50B can accordingly be smaller than the size of the interference pattern 50, 50B.

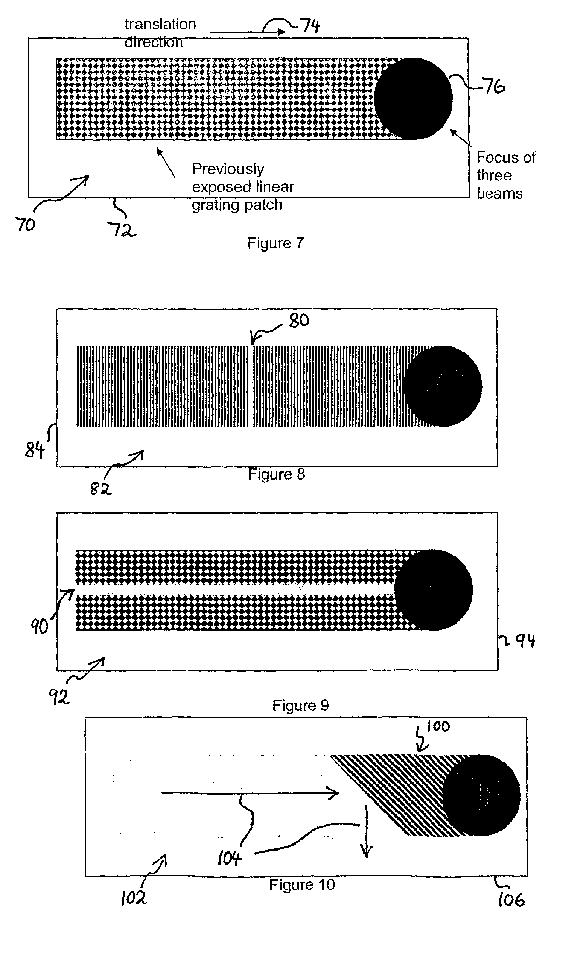

The simultaneous interference of the three laser beams in the example embodiment can be controlled to give all possible 2-D unit cells by Fourier superposition through the control of the relative phase, polarisation and amplitude of the writing beams. These lattice structures can be quite diverse - from simple structures (cubic and hexagonal arrays of dots) to elongated forms that yield, in the limit, linear gratings. Figure 7 shows an example extended 2-D diffraction structure 70 written onto a substrate 72 with the relative movement between the substrate 72 and the interference region/pattern 76 indicated by arrow 74.

The functionality of photo-induced structures can be enabled/modified by a number of processes:

Apodisation describes how the amplitude of the photo-induced structure is modulated on length scales of e.g. 10-1000 microns. Apodisation can e.g. be achieved by (a) control of the amplitude of the beams, or (b) the use of either phase modulation or polarisation modulation to vary the fringe visibility. The latter, (b), has the advantage that the average illumination of the structure (averaged over the period of the structure) is unchanged.

Defects in photo-induced structures are critical to the development of devices in e.g. linear and 2-D photo-induced structures. These can, for example, create resonances that discriminate between wavelengths. The degree of functionality depends on the size of the defects and can range from sub-wavelength size to multiple-wavelength size. The orientation of the defects with respect to the light field depends on the functionality. In the following, examples of defects in optical structures will be described.

*Linear (1-D) Grating Defects -* e.g. in Bragg gratings - are used to create transmission resonances. Figure 8 shows a linear defect 80 in a linear Bragg grating 82, written into a photosensitive substrate 84, creating a transmission resonance.

*2-D Grating Defects -* e.g. as used to channel light in photonic bandgap devices. Figure 9 shows a two-dimensional grating defect in the form of a channel 90 of cancelled photo-induced structure elements in an overall two-dimensional photo-induced structure 92, written into a photosensitive substrate 94.

*Semi-infinite Defects -* these give rise to reflection bands that can be used to steer beams into different directions. This class of defects refer to the absence of photo-induced structures, or more generally to variations of the photo-induced structure. Figure 10 shows an example of a photo-induced structure portion 100 oriented at an angle with respect to a light propagation direction in a waveguide 102, written into a photosensitive substrate 106, for steering a light beam 104.

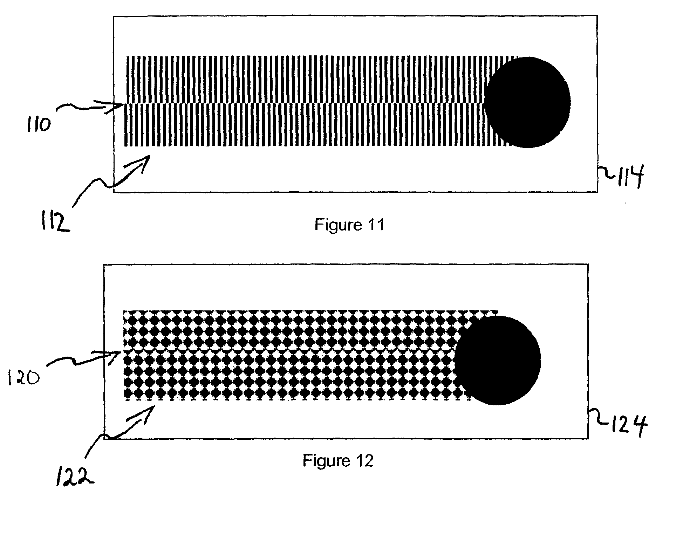

*Dislocation Defects -* can be used to make asymmetric diffractive devices in combination with an underlying waveguide. Figure 11 shows a dislocation defect 110 in a linear photo-induced structure 112, written into a photosensitive substrate 114, whereas Figure 12 shows a dislocation defect 120 in a two-dimensional photo-induced structure 122, written into a photosensitive substrate 124.

In the above Figures 7 to 12 the respective photo-induced structures are shown as being of a transverse size (with respect to the relative movement between the substrates and the interference region of the beams) determined by the size of the interference region in that direction. However, it will be appreciated that the interfering beams may be scanned/oscillated laterally in a direction transverse to the direction of the relative movement, to extend the resulting photo-induced structure in the Y-dimension, with suitable control of the wavefront changes and the velocity of the interference patter changes to write the structure in the frame of the substrate. It is noted that the defect size can be smaller than the size of the interference regi on.

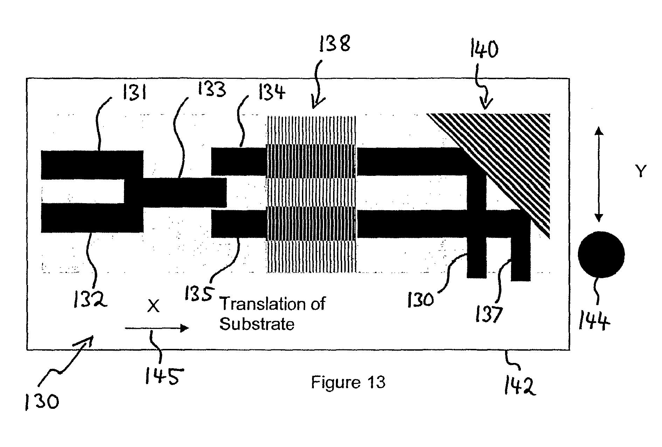

In Figure 13, an example photonics circuit 130 is shown, which comprises a combination of refractive and photo-induced structures, i.e. waveguide traces 131 to 137, grating structure 138 (extending through waveguide traces 134 and 135), and light steering structure 140, all written into the one photosensitive substrate 142. In the writing of photonics circuit 130, the substrate 142 is translated as indicated by arrow 145, while simultaneously scanning the beams (not shown) so as to scan the interference region 144 in a direction transverse to the movement of the substrate 142, thus enabling writing of a structure extended in both the X-direction as well as the Y-direction. Suitable beam shaping can be used to achieve a desired exposure of the substrate during the writing, e.g. to reduce excess exposure through "overlapping" peripheral interference regions between scans.

It will be appreciated by the person skilled in the art that numerous modifications and/or variations may be made to the present invention as shown in the specific embodiments without departing from the spirit or scope of the invention as broadly described. The present embodiments are, therefore, to be considered in all respects to be illustrative and not restrictive.

For example, the preferred embodiment described utilises an interferometer in which three writing beams are brought into interference for the writing of photo-induced structures. However, it will be appreciated that, more generally, *N*-beams (*N ≥* 2) may be brought to interference in an interferometer embodying the present invention, enabling different degrees of design freedom in the writing of photo-induced structures, including e.g. writing of 3-dimensional photo-induced structures. Furthermore, while in the preferred embodiment described, a reflective adaptive optics means is utilised, transmissive adaptive optics means or alternative means for controlling the wavefront of at least one of the writing beams may be used.

In the claims that follow and in the summary of the invention, except where the context requires otherwise due to express language or necessary implication the word "comprising" is used in the sense of "including", i.e. the features specified may be associated with further features in various embodiments of the invention.

## Claims

1. A method of writing a photo-induced structure into a photosensitive material substrate, the method comprising the steps of:
- creating an interference pattern utilising at least two light beams,
- exposing the substrate to the interference pattern for photo-inducing material changes in the substrate, and
- creating an irregularity in the interference pattern by controlling a wavefront of at least one of the beams, for creating a functional defect in the photo-induced structure.

2. A method as claimed in claim 1, wherein the step of controlling the wavefront of at least one of the beams comprises utilising adaptive optics means for altering the wavefront.

3. A method as claimed in claim 2, wherein the adaptive optics means is a reflective or transmissive adaptive optics means.

4. A method as claimed in claims 2 or 3, wherein the adaptive optics means comprises a micro electronic mechanical system (MEMS) device.

5. A method as claimed in claim 4, wherein the MEMS device comprises an array of movable micro mirrors.

6. A method as claimed in claims 2 or 3, wherein the adaptive optics means comprises a transmissive device based on one or more of a group comprising liquid crystal technology, ferroelectric liquid crystal technology, and electrically controllable ferroelectric liquid crystal retarder plates.

7. A method as claimed in any one of claims 1 to 5, wherein the or an adaptive optics means for controlling the wavefront is further utilised to split an incoming light beam to create the at least two light beams for creation of the interference pattern.

8. A method as claimed in any one of the preceding claims, wherein the functional defect comprises a linear defect, whereby the resulting 1-dimensional photo-induced structure exhibits a transmission resonance.

9. A method as claimed in any one of the preceding claims, wherein the method comprises creating a 2-dimensional or 3-dimensional interference pattern.

10. A method as claimed in claim 9, wherein the functional defect comprises a 2-dimensional or 3-dimensional defect.

11. A method as claimed in claim 10, wherein the 2-dimensional or 3 dimensional defect comprises an extended defect.

12. A method as claimed in any one of the preceding claims, wherein the functional defect comprises a dislocation defect, whereby the resulting photo-induced structure is asymmetric.

13. A method as claimed in any one of the preceding claims, wherein the method further comprises the steps of:
- inducing a relative movement between the substrate and an interference region of the beams,
- controlling a relative phase difference between the beams to induce changes in the interference pattern, and
- controlling a velocity of the changes in the interference pattern to write an extended photo-induced structure in the substrate.

14. A method as claimed in claim 13, wherein the relative movement is effected through movement of the substrate and/or scanning of the beams.

15. A method as claimed in claims 13 or 14, wherein the relative movement is effected through a combination of movement of the substrate and simultaneous scanning of the beams in a direction transverse to the movement of the substrate.

16. A method as claimed in any one of claims 13 to 15, wherein the method further comprises the step of further controlling the wavefront of at least one of the beams as a function of the relative movement, whereby the position and/or size and/or shape of the functional defect along the resulting photo-induced extended structure is controlled.

17. A method as claimed in any one of claims 13 to 16, wherein the method further comprises the step of controlling the wavefront of at least one of the beams to change the number of defects created along the photo-induced extended structure.

18. A method as claimed in any one of the preceding claims 13 to 17, wherein the method further comprises the step of controlling the relative phase difference between the beams to vary a pitch of the interference pattern, or to vary a contrast of the interference pattern.

19. A method as claimed in claim 18, wherein the contrast of the interference pattern is controlled to be zero for writing a photo-induced refractive structure.

20. A method as claimed in any one of the preceding claims, wherein the method further comprises the step of shaping the beams to control the exposure of the substrate to the interference pattern.

21. A method as claimed in claim 20, wherein the adaptive optics means is utilised in the shaping of the beams.

22. A method as claimed in any one of the preceding claims, wherein the method further comprises the step of focusing the light beams in the interference region.

23. A method as claimed in any one of the preceding claims, wherein the method further comprises the step of applying feedback corrections during the writing of the photo-induced structure, to achieve desired characteristics of the written photo-induced structure.

24. A method as claimed in claim 23, wherein the feedback corrections are conducted utilising a computer controlled process.

25. A method as claimed in any one of the preceding claims, wherein the photosensitive material substrate has a non-linear photosensitivity, and one or more of the beams are pulsed laser beams, whereby a three-dimensional photo-induced structure can be written in the substrate utilising intensity variations in the created interference pattern.

26. A method as claimed in claim 25, wherein the material change comprises a refractive index change, change in solubility, change in density, change in light transmission/absorption, and/or change in susceptibility to the next technological process.

27. A method as claimed in any one of the preceding claims, wherein the method further comprises the step of controlling the polarisation of at least one of the light beams.

28. A method as claimed in claim 18, wherein the adaptive optics means is utilised in the controlling of the relative phase difference.

29. An interferometer for writing a photo-induced structure into a photosensitive material substrate, the interferometer comprising:
- an interference unit arranged for creating an interference pattern utilising at least two light beams, and
- a control unit for controlling a wavefront of at least one of the beams to create an irregularity in the interference pattern for creating a functional defect in the photo-induced structure.

30. An interferometer as claimed in claim 29, wherein the control unit comprises an adaptive optics element for controlling the wavefront of at least one of the beams for altering the wavefront.

31. An interferometer as claimed in claim 30, wherein the adaptive optics element is a reflective or transmissive adaptive optics element.

32. An interferometer as claimed in claims 30 or 31, wherein the adaptive optics element comprises a micro electronic mechanical system (MEMS) device.

33. An interferometer as claimed in claim 32, wherein the MEMS device comprises an array of movable micro mirrors.

34. An interferometer as claimed in claims 30 or 31, wherein the adaptive optics element comprises a transmissive device based on one or more of a group comprising liquid crystal technology, ferroelectric liquid crystal technology, and electrically controllable ferroelectric liquid crystal technology retarder plates.

35. An interferometer as claimed in any one of claims 29 to 34, wherein the or an adaptive optics element for controlling the wavefront is further arranged for splitting an incoming light beam to create the at least two light beams for creation of the interference pattern.

36. An interferometer as claimed in any one of claims 29 to 35, wherein the control unit is further arranged for controlling a relative phase difference between the beams to induce changes in the interference pattern, and to control a velocity of the changes in the interference pattern to write an extended photo-induced structure in the substrate.

37. An interferometer as claimed in any one of claims 29 to 36, wherein the interferometer further comprises a scanning unit for scanning of the beams during the writing of the photo-induced structure.

38. An interferometer as claimed in claim 36, wherein the control unit is further arranged for controlling the wavefront of at least one of the beams as a function of the relative movement in a manner such as to control the position and/or size and/or shape of the functional defect along the resulting photo-induced extended structure.

39. An interferometer as claimed in claims 36 or 38, wherein the control unit is further arranged for controlling the wavefront of at least one of the beams to change the number of defects created along the photo-induced extended structure.

40. An interferometer as claimed in any one of claims 36, 38 or 39, wherein the control unit is further arranged for controlling the relative phase difference between the beams to vary a pitch of the interference pattern, or to vary a contrast of the interference pattern.

41. An interferometer as claimed in claim 40, wherein the control unit is arranged to utilise the adaptive optics element for the controlling of the relative phase difference.

42. An interferometer as claimed in any one of claims 29 to 41, wherein the interferometer further comprises a beam shaping unit for shaping the beams to, in use, control the exposure of the substrate to the interference pattern.

43. An interferometer as claimed in claim 42, wherein the beam shaping unit comprises the or an adaptive optics element.

44. An interferometer as claimed in any one of claims 29 to 43, wherein the interferometer further comprises a focusing unit for focusing the light beams in the interference region.

45. An interferometer as claimed in any one of claims 29 to 44, wherein the interferometer further comprises a feedback unit for applying feedback corrections during the writing of the photo-induced structure, to achieve desired characteristics of the written photo-induced structure.

46. An interferometer as claimed in claim 45, wherein the feedback unit comprises a computer processor.

47. An interferometer as claimed in any one of claims 29 to 46, wherein the photosensitive material substrate has a non-linear photosensitivity, and one or more of the beams are pulsed laser beams, whereby a three-dimensional photo-induced structure can be written in the substrate utilising intensity variations in the created interference pattern.

48. An interferometer as claimed in any one of claims 29 to 47, wherein the control unit is further arranged, in use, to control the polarisation of at least one of the light beams.

49. A photo-induced structure written into a photosensitive material substrate utilising the method as claimed in any one of claims 1 to 28 or the interferometer as claimed in any one of claims 29 to 48.

50. A method of writing a photo-induced structure into a photosensitive material substrate, substantially as herein described with reference to the accompanying drawings.

51. An interferometer for writing a photo-induced structure into a photosensitive material substrate, substantially as herein described with reference to the accompanying drawings.
